# EUROPÄISCHE PATENTSCHRIFT

(11) **EP 0 762 515 B1**
(45) Veröffentlichungstag und Bekanntmachung des Hinweises auf die Patenterteilung: **06.10.2004**
(21) Anmeldenummer: 96112485.6
(22) Anmeldetag: 02.08.1996
(51) Int. Cl.: H01L 33/00

(54) **Optikkörper für mindestens eine LED**
Optical body for at least one light emitting diode
Corps optique pour au moins une diode émettrice de lumière

(30) Priorität: 25.08.1995 DE 19531295
(43) Veröffentlichungstag der Anmeldung: 12.03.1997
(73) Patentinhaber: Schefenacker Vision Systems Germany GmbH & Co. KG, 73730 Esslingen (DE)
(72) Erfinder: Zwick, Hubert, 70184 Stuttgart (DE); Sandig, Hellfried, 73730 Esslingen (DE)
(74) Vertreter: Jackisch-Kohl, Anna-Katharina

(56) Entgegenhaltungen:
- GB-A- 1 423 011
- US-A- 3 512 027
- US-A- 4 254 453
- US-A- 4 698 730
- PATENT ABSTRACTS OF JAPAN vol. 012, no. 207 (E-621), 14. Juni 1988 (1988-06-14) & JP 63 005580 A (MITSUBISHI CABLE IND LTD), 11. Januar 1988 (1988-01-11)

## Beschreibung

Die Erfindung betrifft einen Optikkörper für mindestens eine LED nach dem Oberbegriff des Anspruches 1.

Solche Optikkörper dienen dazu, das von einer LED ausgestrahlte Licht in eine vorgegebene Strahlrichtung zu lenken. Die LED ist hierzu in den Optikkörper eingebettet, der aus entsprechend durchsichtigem Material besteht. Das von der LED ausgesandte Licht gelangt entweder an die Außenseite des Optikkörpers oder an dessen Stirnseite. An der Außenseite des Optikkörpers werden die Strahlen zur Stirnseite hin reflektiert. Beim Austritt an der Stirnseite des Optikkörpers werden die Strahlen in die gewünschte Richtung gebrochen. Abgesehen von der aufwendigen Fertigung eines solchen Optikkörpers ist die Lichtausnutzung beschränkt.

Beim gattungsgemäßen Optikkörper (GB-A 1 423 011) ist die von einem paraboloidförmigen Reflektor umgebene LED im Optikkörper eingebettet. Vor dem Reflektor mit der LED ist eine Aufnahme mit einer weiteren Reflexionsfläche vorgesehen. Die von der LED ausgesandten Strahlen werden vom Reflektor zum weiteren Reflektor reflektiert, der die Strahlen durch den Optikkörper hindurch zur Außenseite des Optikkörpers reflektiert. Aufgrund der in Strahlungsrichtung hintereinander liegenden Reflektorflächen hat der Optikkörper eine verhältnismäßig große Länge. Zudem ist die Herstellung aufwendig.

Bei einem anderen bekannten Optikkörper (US-A-3 512 027) ist die LED in einer Aufnahme untergebracht, deren Wandung mindestens teilweise eine als Paraboloidfläche ausgebildete Reflexesionsfläche bildet. Die Aufnahme ist teilweise mit einer transparenten Masse gefüllt. Die Fertigung dieses Optikkörpers ist aufwendig. Ferner ist die Lichtausnutzung des Optikkörpers eingeschränkt.

Ein anderer bekannter Optikkörper (JP-A-63 005 580) ist in einer mit einem Substrat gefüllten Aufnahme untergebracht. Die Wandung der Aufnahme bildet eine paraboloidförmige Reflektorfläche, an der die Strahlen der LED nach außen reflektiert werden. Die Lichtausnutzung ist nur beschränkt.

Der Erfindung liegt die Aufgabe zugrunde, den gattungsgemäßen Optikkörper so auszubilden, daß er einfach und kostengünstig gefertigt werden kann und eine hohe Ausnutzung des von der LED abgestrahlten Lichtes gewährleistet.

Diese Aufgabe wird beim gattungsgemäßen Optikkörper erfindungsgemäß mit den kennzeichnenden Merkmalen des Anspruches 1 gelöst.

Beim erfindungsgemäßen Optikkörper wird die LED in die Aufnahme des Optikkörpers eingesetzt, die als Aufnahmeraum ausgebildet ist. Die LED wird nicht in den Optikkörper eingebettet, so daß die Herstellung des Optikkörpers einfach und vor allen Dingen kostengünstig ist. Das von der LED ausgestrahlte Licht wird an der Innenwand der Aufnahme reflektiert. Da sie als Paraboloidfläche ausgebildet ist und die von der LED ausgesandten Strahlen von dieser Fläche zu einer weiteren Reflexionsfläche gebrochen und in Hauptstrahlrichtung reflektiert werden, kann das Verhältnis von Innendurchmesser der Aufnahme zur axialen Länge der Paraboloidfläche sehr klein sein. Dadurch ergibt sich eine optimale Ausnutzung des von der LED ausgestrahlten Lichtes. Der erfindungsgemäße Optikkörper kann für eine Leuchte eines Kraftfahrzeuges, beispielsweise für eine hochgesetzte zentrale Bremsleuchte, eingesetzt werden. Je nach Breite und/oder Höhe der Leuchte können mehrere Optikkörper neben- und/oder übereinander angeordnet werden. Die Optikkörper gewährleisten eine optimale Ausleuchtung einer die Leuchte abdeckenden Lichtscheibe.

Weitere Merkmale der Erfindung ergeben sich aus den weiteren Ansprüchen, der Beschreibung und den Zeichnungen.

Die Erfindung wird anhand zweier in den Zeichnungen dargestellter Ausführungsbeispiele näher erläutert. Es zeigen
- Fig. 1: in perspektivischer Darstellung einen erfindungsgemäßen Optikkörper, in dem eine LED untergebracht ist,
- Fig. 2: einen Axialschnitt durch den Optikkörper gemäß Fig. 1,
- Fig. 3: den Optikkörper gemäß Fig. 1 teilweise in Ansicht und teilweise im Axialschnitt,
- Fig. 4: im Längsschnitt mehrere zu einem Leuchtenkörper zusammengefaßte Optikkörper.

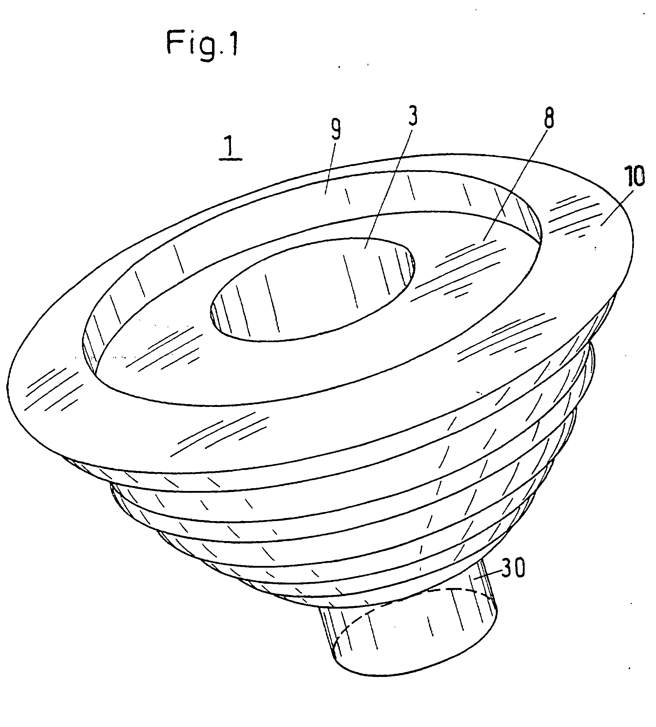

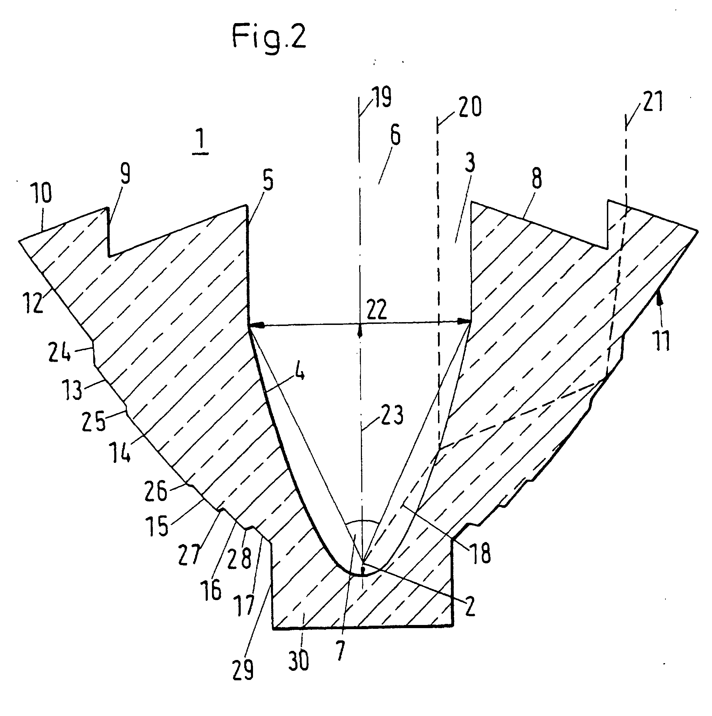

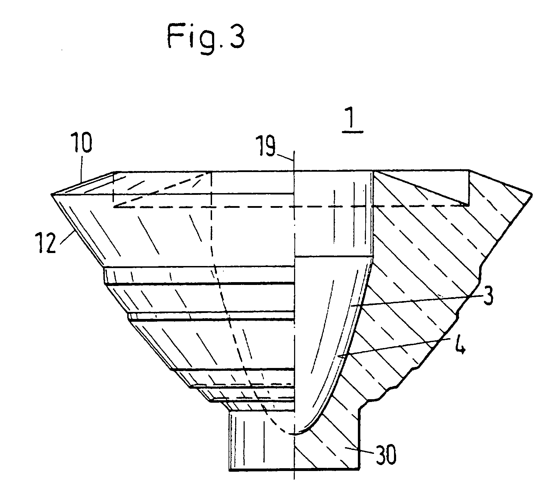

Im Optikkörper 1 gemäß den Fig. 1 bis 3 ist eine in Fig. 2 angedeutete LED 2 untergebracht. Der Optikkörper 1 ist so ausgebildet, daß ein hoher Prozentsatz des von der LED 2 ausgestrahlten Lichtes genutzt wird.

Der Optikkörper 1 ist als Rotationskörper ausgebildet und hat eine zentrale Aufnahme 3, in der die LED 2 untergebracht ist. Die Aufnahme 3 wird über den größeren Teil ihrer axialen Länge von einer Paraboloidfläche 4 begrenzt, die an eine Zylinderfläche 5 anschließt, die sich bis zur Stirnseite des Optikkörpers 1 erstreckt. Die Aufnahme 3 ist an der einen Stirnseite des Optikkörpers 1 offen, der für den Austritt zumindest eines Teils des von der LED 2 ausgestrahlten Lichtes eine entsprechende kreisförmige Austrittsöffnung 6 (Fig. 2) aufweist. Der Übergang von der Paraboloidfläche 4 in die Zylinderfläche 5 liegt, bezogen auf den Brennpunkt der Paraboloidfläche, in dem die LED 2 angeordnet ist, unter einem Öffnungswinkel 7 von etwa 50°. Selbstverständlich ist dieser Kegelwinkel je nach Tiefe der Aufnahme 3 und/oder der radialen Breite unterschiedlich. Der Übergang von der Paraboloidfläche 4 zur Zylinderfläche 5 ist so gewählt, daß ein großer Teil des von der LED 2 ausgestrahlten Lichtes auf die Paraboloidfläche 4 trifft und an ihr in noch zu beschreibender Weise reflektiert und gebrochen wird.

Die Zylinderfläche 5 geht an der die Austrittsöffnung 6 aufweisenden Stirnseite des Optikkörpers 1 in eine Kegelfläche 8 über, die radial nach außen abfällt und an eine Zylinderfläche 9 anschließt, deren Radius größer ist als der Radius der Zylinderfläche 5. Die Zylinderfläche 9 liegt koaxial zur Zylinderfläche 5, hat jedoch geringere axiale Länge als diese. Die Zylinderfläche 9 schließt an eine weitere Kegelfläche 10 an, die wiederum radial nach außen abfällt und sich bis zur Außenseite des Optikkörpers 1 erstreckt. Die beiden Kegelflächen 8, 10 liegen parallel zueinander, wobei die radial äußere Kegelfläche 10 geringere radiale Breite hat als die radial innere Kegelfläche 8. Die beiden Kegelflächen 8, 10 sowie die sie verbindende Zylinderfläche 9 liegen in der die Austrittsöffnung 6 aufweisenden Stirnseite des Optikkörpers 1.

Der Optikkörper 1 besteht aus glasklarem Material und ist an der Außenseite 11 mit einer Reflexionsschicht versehen, die vorzugsweise durch eine Verspiegelung der Außenseite 11 gebildet wird. Die Außenseite 11 ist in einzelne, jeweils kegelförmige Reflexionsflächen 12 bis 17 unterteilt, die jeweils koaxial zueinander liegen. Sämtliche Reflexionsflächen haben in der Darstellung gemäß Fig. 2 nach unten schließende Kegelflächen. Die Radien der Kegelflächen 12 bis 17 nehmen von der Stirnseite 8 bis 10 des Optikkörpers 1 aus ab. Dadurch ist der Optikkörper 1 von seiner Stirnseite 8 bis 10 aus verjüngt ausgebildet. An den einzelnen Reflexionsflächen 12 bis 17 werden die von der LED 2 ausgehenden und an der Paraboloidfläche 4 gebrochenen Strahlen jeweils so reflektiert, daß sämtliche Strahlen an der Stirnseite 8 bis 10 des Optikkörpers 1 vorzugsweise parallel zueinander austreten. Wie Fig. 2 beispielhaft für den von der LED 2 ausgehenden Strahl 18 zeigt, wird er zunächst an der Paraboloidfläche 4 derart reflektiert, daß er parallel zur Achse 19 des Optikkörpers 1 aus der Austrittsöffnung 6 austritt. Der Strahl 18 wird außerdem an der Paraboloidfläche 4 gebrochen und gelangt auf die Reflexionsfläche 13 der Außenseite 11 des Optikkörpers 1. An der Reflexionsfläche 13 wird der Strahl 18 zur Kegelfläche 10 hin reflektiert, an der er beim Durchtritt derart gebrochen wird, daß er ebenfalls parallel zur Achse 19 aus der Stirnseite 8 bis 10 des Optikkörpers 1 austritt. Der Strahl 18 wird somit in zwei zueinander parallele Teilstrahlen 20, 21 aufgeteilt. Auf diese Weise werden sämtliche, von der LED 2 ausgehende Strahlen an der Paraboloidfläche 4 teilweise reflektiert und teilweise gebrochen. Je nach Strahlwinkel gelangen die an der Paraboloidfläche 4 gebrochenen Strahlen auf eine der Reflexionsflächen 12 bis 17, an der diese Strahlen dann zu einer der beiden stirnseitigen Kegelflächen 8, 10 reflektiert werden. Dort werden diese Strahlen in der beschriebenen Weise beim Austritt derart gebrochen, daß der Teilstrahlen achsparallel verlaufen.

Die seitlichen Reflexionsflächen 12 bis 17 sind im dargestellten Ausführungsbeispiel so geformt, daß die Lichtstrahlen nach erneuter Brechung an den stirnseitigen Flächen parallel zur Achse 19 reflektiert werden. Selbstverständlich können die Reflexionsflächen 12 bis 17 und/oder die stirnseitigen Kegelflächen 8, 10 so geformt sein, daß die Strahlen auch konvergierend oder divergierend verlaufen. Infolge der beschriebenen Ausbildung wird eine große, leuchtende Austrittsfläche 6, 8 bis 10 am Optikkörper 1 erzeugt. Ein hoher Prozentsatz des von der LED 2 ausgestrahlten Lichtes wird somit genutzt, so daß eine hohe Lichtausbeute erzielt wird.

Die Reflexionsflächen 12 bis 17 können auch Paraboloid- und/oder Freiformflächen sein. Es ist auch möglich, die Reflexionsflächen je nach Anwendungsfall als Kegel- und/oder Paraboloid- und/oder Freiformflächen auszubilden.

Je nach dem Winkel, unter dem die von der LED 2 ausgesandten Strahlen auf die Paraboloidfläche 4 treffen, werden die Strahlen nicht gebrochen, sondern lediglich an der Paraboloidfläche 4 reflektiert. Die Paraboloidfläche 4 ist so ausgebildet, daß das Licht in gewünschter Weise reflektiert wird.

Die Paraboloidfläche 4 hat ein sehr kleines Verhältnis von Öffnung 22 zu Tiefe 23 (Fig. 2). Unter Öffnung 22 ist hierbei der größte Durchmesser der Paraboloidfläche 4 zu verstehen. Infolge dieses kleinen Verhältnisses ergibt sich, daß das von der LED 2 ausgestrahlte Licht optimal genutzt wird, ohne daß die Austrittsöffnung 6 einen zu kleinen Durchmesser oder die Paraboloidfläche 4 eine zu große axiale Tiefe 23 aufweist. Dadurch zeichnet sich der Optikkörper 1 durch eine kompakte Bauform aus. Insbesondere ist die Außenseite 11 verhältnismäßig klein ausgebildet, so daß sie einfach und mit hoher Qualität zur Erzeugung der Reflexionsschicht mit der Spiegelschicht bedampft werden kann.

Die an die stirnseitige Kegelfläche 10 anschließende Reflexionsfläche 12 geht über eine einen sehr kleinen Kegelwinkel aufweisende Kegelfläche 24 in die Reflexionsfläche 13 über. Sie schließt über eine weitere, axial sehr kurze Kegelfläche 25 an die Reflexionsfläche 14 an. Sie ist ihrerseits über eine ebenfalls axial sehr kurze Kegelfläche 26 mit der Reflexionsfläche 15 verbunden. Sie geht über eine weitere Kegelfläche 27 in die Reflexionsfläche 16 über, die über eine Kegelfläche 28 an die Reflexionsfläche 17 anschließt. Sie geht in eine Zylinderfläche 29 über, die eine Mantelfläche eines Ansatzes 30 des Optikkörpers 1 bildet. Da die Zylinderfläche 29 keine Reflexionseigenschaften aufweist, ist sie auch nicht verspiegelt.

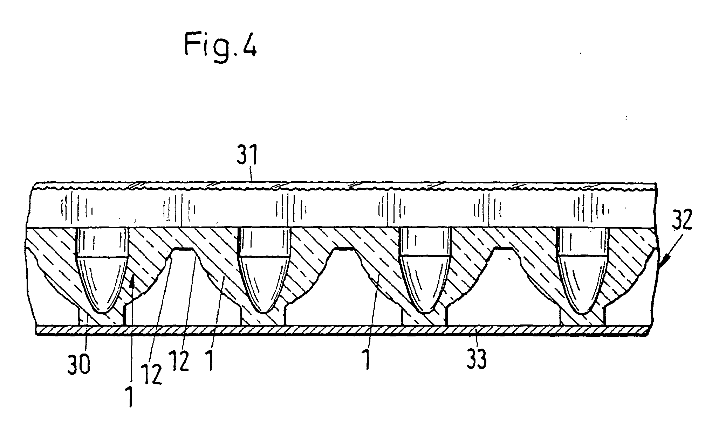

Fig. 4 zeigt eine aus mehreren nebeneinander liegenden Optikkörpern 1 gebildete Optikeinheit, die hinter einer Lichtscheibe 31 einer Leuchte 32 angeordnet ist. Die einzelnen Optikkörper 1 sind jeweils gleich ausgebildet wie das Ausführungsbeispiel gemäß den Fig. 1 bis 3. Vorteilhaft sind die Optikkörper 1 einstückig miteinander ausgebildet. Sie gehen im Bereich der Reflexionsflächen 12 ineinander über. Mit ihrem zylindrischen Ansatz 30 liegen die Optikkörper 1 an einer Rückwand 33 an, an der sie beispielsweise angeklebt sein können. In jedem Optikkörper 1 ist eine LED angeordnet. Die Optikkörper 1 können hinter- und/oder nebeneinander angeordnet sein. Aufgrund der beschriebenen hohen Lichtausbeute wirkt das von den einzelnen LEDs abgegebene Licht als einheitliche Lichtfläche, so daß von außen nicht erkennbar ist, daß das durch die Lichtscheibe 31 fallende Licht von einzelnen LEDs 2 kommt. Die Lichtscheibe 31 wird über ihre jeweilige Leuchtfläche gleichmäßig ausgeleuchtet.

Die Lichtscheibe 31 kann eingefärbt sein, beispielsweise einen roten Farbton aufweisen, wenn die Leuchte 32 als Bremsleuchte verwendet wird. Ebenso ist es möglich, die Lichtscheibe 31 nicht einzufärben und dafür die LEDs 2 in entsprechendem Farbton zu verwenden.

## Patentansprüche

1. Optikkörper (1) für mindestens eine LED (2), mit mindestens einer Reflexionsfläche (4) für von der LED (2) ausgesandtes Licht, wobei die LED (2) in einer Aufnahme öffnung (3) des Optikkörpers (1) untergebracht ist, deren Innenwandung zumindest teilweise die Reflexionsfläche (4) bildet, die eine Paraboloidfläche ist,
**dadurch gekennzeichnet, daß** die von der LED (2) ausgesandten Strahlen (18) teilweise an der Paraboloidfläche (4) zu wenigstens einer weiteren Reflexionsfläche (12 bis 17) hingebrochen werden, welche die Strahlen in Hauptstrahlrichtung reflektiert.

2. Optikkörper nach Anspruch 1,
**dadurch gekennzeichnet, daß** die weitere Reflexionsfläche (12 bis 17) an der Außenseite (11) des Optikkörpers (1) vorgesehen ist.

3. Optikkörper nach Anspruch 1 oder 2,
**dadurch gekennzeichnet, daß** die weitere Reflexionsfläche (12 bis 17) durch eine Verspiegelung zumindest eines Teiles der Außenseite (11) des Optikkörpers (1) gebildet ist.

4. Optikkörper nach einem der Ansprüche 1 bis 3,
**dadurch gekennzeichnet, daß** die weitere Reflexionsfläche (12 bis 17) kegelförmig ausgebildet ist.

5. Optikkörper nach einem der Ansprüche 1 bis 4,
**dadurch gekennzeichnet, daß** die weitere Reflexionsfläche (12 bis 17) eine Paraboloid- und/oder Freiformfläche ist.

6. Optikkörper nach einem der Ansprüche 1 bis 5,
**dadurch gekennzeichnet, daß** an der Außenseite (11) mehrere weitere Reflexionsflächen (12 bis 17) axial hintereinander angeordnet sind.

7. Optikkörper nach einem der Ansprüche 1 bis 6,
**dadurch gekennzeichnet, daß** der Optikkörper (1) etwa kegelförmig ausgebildet ist.

8. Optikkörper nach Anspruch 7,
**dadurch gekennzeichnet, daß** der Optikkörper (1) in Strahlrichtung im Querschnitt erweitert ausgebildet ist.

9. Optikkörper nach einem der Ansprüche 1 bis 8,
**dadurch gekennzeichnet, daß** die reflektierten oder gebrochenen Strahlen (18, 20, 21) an der Stirnseite (8 bis 10) des Optikkörpers (1) austreten.

10. Optikkörper nach Anspruch 9,
**dadurch gekennzeichnet, daß** die innerhalb des Optikkörpers (1) verlaufenden Strahlen beim Durchtritt durch die Stirnseite (8 bis 10) des Optikkörpers (1) gebrochen werden.

11. Optikkörper nach einem der Ansprüche 1 bis 10,
**dadurch gekennzeichnet, daß** die Stirnseite (8 bis 10) des Optikkörpers (1) durch wenigstens eine Kegelfläche (8, 10) gebildet ist, welche die Austrittsöffnung (6) der Aufnahme (3) für die LED (2) umgibt.

12. Optikkörper nach einem der Ansprüche 1 bis 11,
**dadurch gekennzeichnet, daß** der Optikkörper (1) aus glasklarem Material, vorzugsweise Kunststoff, besteht.

## Claims

1. Optical body (1) for at least one LED (2), with at least one reflection face (4) for the light emitted by the LED (2), the LED (2) being fitted in an accommodation opening (3) of the optical body (1), the inner wall of which at least partially forms the reflection face (4), which is a paraboloid face, **characterized in that** the rays (18) emitted by the LED (2) are partially refracted at the paraboloid face (4) towards at least one further reflection face (12 to 17), which reflects the rays into the primary beam direction.

2. Optical body according to Claim 1, **characterized in that** the further reflection face (12 to 17) is provided on the outer side (11) of the optical body (1).

3. Optical body according to Claim 1 or 2, **characterized in that** the further reflection face (12 to 17) is formed by rendering at least a part of the outer side (11) of the optical body (1) reflective.

4. Optical body according to one of Claims 1 to 3, **characterized in that** the further reflection face (12 to 17) is conically designed.

5. Optical body according to one of Claims 1 to 4, **characterized in that** the further reflection face (12 to 17) is a paraboloid and/or freeform face.

6. Optical body according to one of Claims 1 to 5, **characterized in that** a plurality of further reflection faces (12 to 17) are arranged axially one behind the other on the outer side (11).

7. Optical body according to one of Claims 1 to 6, **characterized in that** the optical body (1) is of approximately conical design.

8. Optical body according to Claim 7, **characterized in that** the optical body (1) is designed to be cross-sectionally widened in the ray direction.

9. Optical body according to one of Claims 1 to 8, **characterized in that** the reflected or refracted rays (18, 20, 21) emerge from the end side (8 to 10) of the optical body (1).

10. Optical body according to Claim 9, **characterized in that** the rays propagating inside the optical body (1) are refracted when they pass through the end side (8 to 10) of the optical body (1).

11. Optical body according to one of Claims 1 to 10, **characterized in that** the end side (8 to 10) of the optical body (1) is formed by at least one cone face (8, 10), which surrounds the exit opening (6) of the accommodation (3) for the LED (2).

12. Optical body according to one of Claims 1 to 11, **characterized in that** the optical body (1) is made of glass-ceramic material, preferably plastic.

## Revendications

1. Corps optique (1) pour au moins une diode LED (2), comportant au moins une surface réfléchissante (4) pour la lumière émise par la diode LED (2), la diode LED (2) étant logée dans une ouverture de logement (3) du corps optique (3), dont la paroi intérieure forme au moins partiellement une surface réfléchissante (4), qui est une structure parabolique, **caractérisé en ce que** les rayons (18) émis par la diode LED (2) sont réfractés partiellement au niveau de la surface parabolique (4) en direction d'au moins une autre surface réfléchissante (12 à 17), qui réfléchit les rayons dans la direction de rayonnement principale.

2. Corps optique selon la revendication 1, **caractérisé en ce que** l'autre surface réfléchissante (12 à 17) est prévue sur le côté extérieur (11) du corps optique (1).

3. Corps optique selon la revendication 1 ou 2, **caractérisé en ce que** l'autre surface réfléchissante (12 à 17) est formée par une métallisation d'au moins une partie du côté extérieur (20) du corps optique (1).

4. Corps optique selon l'une des revendications 1 à 3, **caractérisé en ce que** l'autre surface réfléchissante (12 à 17) est réalisée en forme de cône.

5. Corps optique selon l'une des revendications 1 à 4, **caractérisé en ce que** l'autre surface réfléchissante (12 à 17) est une surface parabolique et/ou une surface de forme libre.

6. Corps optique selon l'une des revendications 1 à 5, **caractérisé en ce que** plusieurs surfaces réfléchissantes (12 à 17) sont disposées axialement les unes derrière les autres sur le côté extérieur (11).

7. Corps optique selon l'une des revendications 1 à 6, **caractérisé en ce que** le corps optique (1) est agencé avec une forme approximativement conique.

8. Corps optique selon la revendication 7, **caractérisé en ce que** le corps optique (1) est agencé avec une forme élargie en coupe transversale dans la direction du rayonnement.

9. Corps optique selon l'une des revendications 1 à 8, **caractérisé en ce que** les rayons réfléchis ou rétractés (18, 20, 21) sortent sur la face frontale (8 à 10) du corps optique (1).

10. Corps optique selon la revendication 9, **caractérisé en ce que** les rayons, qui s'étendent à l'intérieur du corps optique (1), sont réfractés lorsqu'ils traversent la face frontale (8 à 10) du corps optique (1).

11. Corps optique selon la revendication 10, **caractérisé en ce que** la face frontale (8 à 10) du corps optique (1) est formée par au moins une surface conique (8, 10), qui entoure l'ouverture de sortie (6) du logement (3) pour la diode LED (2).

12. Corps optique selon l'une des revendications 1 à 11, **caractérisé en ce que** le corps optique (1) est réalisé en un matériau transparent, de préférence une matière plastique.
